# EUROPÄISCHE PATENTSCHRIFT

(11) **EP 3 492 936 B1**
(45) Veröffentlichungstag und Bekanntmachung des Hinweises auf die Patenterteilung: **04.03.2020**
(21) Anmeldenummer: 18208544.9
(22) Anmeldetag: 27.11.2018
(51) Int. Cl.: G01R 31/26, G01R 35/00, H05B 33/08

(54) **TEMPERATUR- UND INTENSITÄTSKALIBRIERTE REFERENZLICHTQUELLE**
TEMPERATURE AND INTENSITY CALIBRATED REFERENCE LIGHT SOURCE
SOURCE DE LUMIÈRE DE RÉFÉRENCE ÉTALONNÉE EN TEMPÉRATURE ET EN INTENSITÉ

(30) Priorität: 30.11.2017 DE 102017128370
(43) Veröffentlichungstag der Anmeldung: 05.06.2019
(73) Patentinhaber: Bundesdruckerei GmbH, 10969 Berlin (DE)
(72) Erfinder: Vonrüty, Mario, 10969 Berlin (DE); Herrmann, Klaus, 30419 Hannover (DE); Rosenbusch, Tobias, 10249 Berlin (DE)
(74) Vertreter: Bittner, Thomas L.

(56) Entgegenhaltungen:
- EP-A1- 0 856 726
- CH-A2- 707 089

## Beschreibung

Optische Messungen, die sich auf eine Helligkeit einer emittierten oder rückgestrahlten Strahlung beziehen, unterliegen oftmals verschiedensten Faktoren, so dass unterschiedliche Messungen nicht zueinander in Bezug gesetzt werden können.

Trotz Kalibrierung einer strahlungsmessenden Einrichtung mittels einer Referenzlichtlichtquelle können Messwertvariationen auftreten, die auf einen Unterschied in einer Betriebstemperatur zurückzuführen sind. In einem Labor mit einem hohen Anteil an manueller Tätigkeit ist dies durch Mehrarbeit des Laborpersonals kompensierbar. In einem industriellen Prozess einer Prüfung von Wert- oder Sicherheitsdokumenten hingegen, ist eine gesonderte Lösung erforderlich, zumal eine kommerzielle Referenzlichtquelle oftmals zu teuer ist, als dass sie in einer industriellen Anlage verbaut werden kann.

In der Schrift EP 0 856 726 A1 ist ein Verfahren zur Temperaturkompensation bei Messsystemen beschrieben.

Die vorliegende Erfindung betrifft Verfahren und Vorrichtung zur Bestimmung eines temperaturstabilisierten Arbeitspunktes einer eine LED umfassenden Referenzlichtquellenanordnung nach den unabhängigen Ansprüchen. Ausführungsformen sind in den untergeordneten Ansprüchen definiert.

Im Weiteren werden Ausführungsformen der Erfindung mit Bezugnahme auf die Figuren der anliegenden Zeichnung erläutert. Es zeigt:
- Figur 1:: eine Anordnung eines Lichtquellenapparats, einer Lichterfassungskomponente sowie einer Messwerterfassung in verschiedenen Abwandlungen a) bis e);
- Figur 2:: eine Referenzlichtquelle, die aus einer LED mit Vorwiderstand gebildet ist;
- Figur 3:: eine Anordnung zur Bestimmung eines temperaturstabilisierten Arbeitspunktes einer eine LED umfassenden Referenzlichtquellenanordnung; und
- Figur 4:: ein Kennlinienfeld zur Bestimmung eines temperaturstabilisierten Arbeitspunktes einer eine LED umfassenden Referenzlichtquellenanordnung.

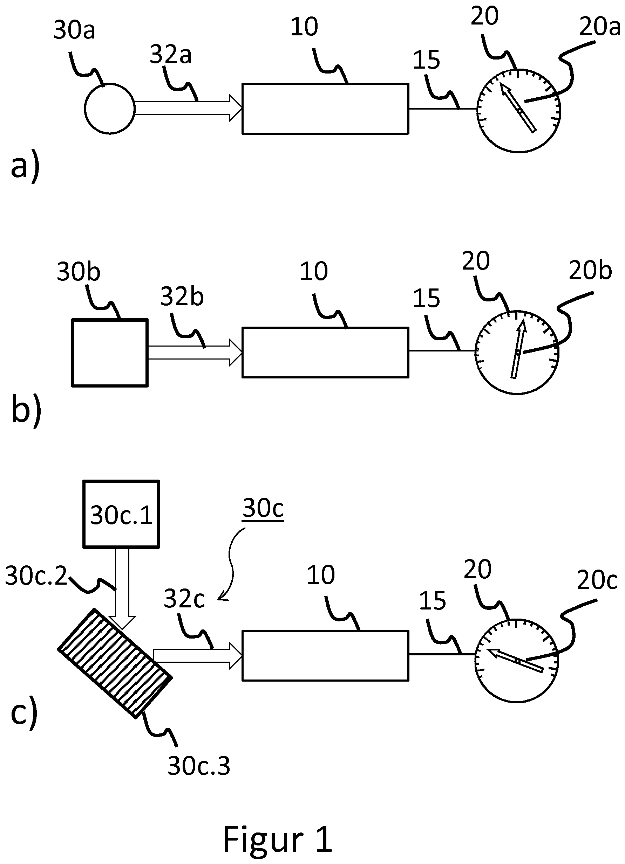

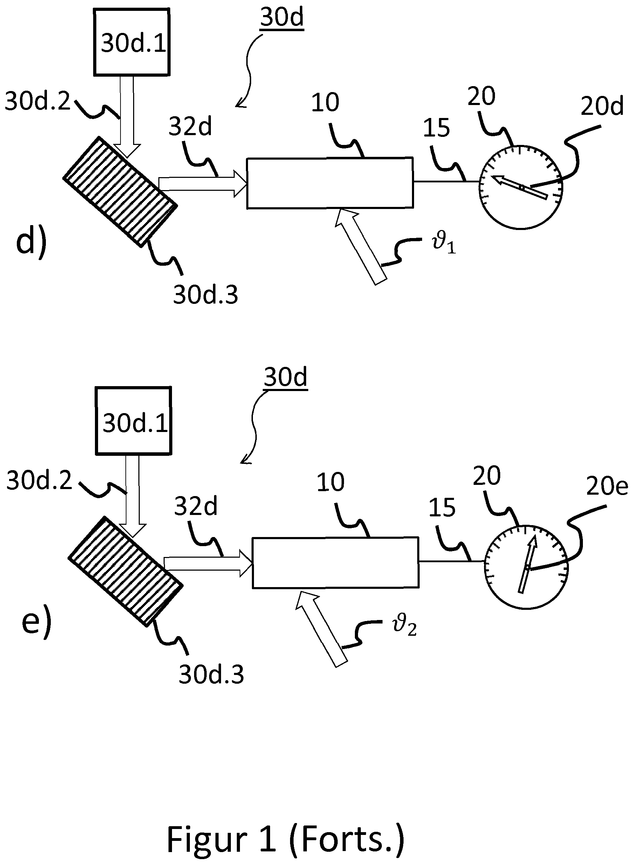

Figur 1 zeigt schematisch eine Anordnung eines Lichtquellenapparats, einer Lichterfassungskomponente sowie einer Messwerterfassung in verschiedenen Abwandlungen a) bis e).

Figur 1a) zeigt eine Lichtquelle 30a, die beispielsweise eine Referenzlichtquelle 30a sein kann, die eine Strahlung 32a emittiert, welche, zumindest teilweise, auf die Lichterfassungskomponente 10 fallen kann. Bei der Lichterfassungskomponente 10 kann es sich um jegliche lichtempfindliche elektronische Komponente handeln, beispielsweise eine Photodiode, einen Phototransistor, einen lichtabhängigen Widerstand, einen Photomultiplier. Ein Photomultiplier kann einen Vorteil einer sehr hohen Lichtempfindlichkeit aufweisen, welche insbesondere bei schwachem Licht erforderlich sein kann.

Das Signal von der Lichterfassungskomponente 10 kann über eine Leitung 15 an eine schematisch dargestellte Messwerterfassung 20 geleitet sein, die einen Messwert 20a anzeigen kann. Es ist dem Fachmann klar, dass es sich bei der Messwerterfassung 20 nicht - wie dargestellt - um ein Zeigerinstrument handeln muss. Die Messwerterfassung 20 kann als digitales Aufzeichnungsgerät mit Mikroprozessorsteuerung ausgeführt sein, worin außer den Messwerten zusätzlich die Messparameter abgespeichert werden könne, wie beispielsweise Art der Lichtquelle, Zeitpunkt der Messung, usw. Die Referenzlichtquelle 30a kann eine kommerziell erhältliche Referenzlichtquelle sein. Sie kann geeignet sein, eine absolute Kalibrierung vorzunehmen.

Die folgenden Figuren weisen teilweise gleiche oder ähnliche Bezugszeichen auf, die eine gleiche oder ähnliche Bedeutung wie in Figur 1a) haben.

Figur 1b) zeigt eine zu Figur 1a) ähnliche Anordnung, wobei hier eine alternative Referenzlichtquelle 30b dargestellt ist, die eine Strahlung 32b emittieren kann. Die Strahlung 32b wird wie in Figur 1a) erfasst und gewandelt, führt zu einem Messwert 20b, der unterschiedlich zu dem Messwert 20a sein kann. Die alternative Referenzlichtquelle 30b kann eine Lichtquelle sein, die gemäß dem nachstehend beschrieben Verfahren kalibriert sein kann.

Die Figur 1c) zeigt eine zu Figur 1a) ähnliche Anordnung, wobei hier eine Betriebssituation dargestellt sein kann, in der eine Lichtquelle 30c gebildet sein kann durch eine Strahlungsquelle 30c.1, die eine Emissionsstrahlung 30c.2 emittieren kann, welche auf ein zu prüfendes Objekt 30c.3 fallen kann und hernach - zumindest teilweise - als eine remittierte Strahlung 32c der Lichterfassungskomponente 10 zugeführt werden kann. Der Messwert 20c kann erheblich kleiner als die Messwerte 20a und 20b sein.

Mit von einem Objekt "remittierter" Strahlung soll hierin insbesondere jede Art von Strahlung gemeint sein, die von dem Objekt ausgeht, also Reflektion, Streuung, Fluoreszenz oder fluoreszenz-ähnliche Prozesse. Es ist zu erwarten, dass die Lichtintensität der Lichtquelle 30c gering sein kann, was durch den entsprechend geringen Messwert 20c wiedergegeben wird.

Die Figur 1d) zeigt eine zur Figur 1c) ähnliche Anordnung, wobei hier die gesamte Anordnung eine Temperatur ϑ₁ aufweist. Dies ist symbolisiert durch einen Pfeil, der auf die Lichterfassungskomponente 10 gerichtet ist. Natürlich weisen sämtliche Komponenten, die in Figur 1d) dargestellt sind, dieselbe Temperatur ϑ₁ auf.

Die Strahlung der Strahlungsquelle 30d kann in der zuvor beschriebenen Weise erfasst werden.

Die Figur 1e) zeigt eine zur Figur 1d) ähnliche Anordnung auf, mit derselben Strahlungsquelle 30d. Allerdings können sämtliche Komponenten in der Figur 1e) eine Temperatur ϑ₂ aufweisen, die von der Temperatur ϑ₁ abweicht. Dementsprechend kann es sein, dass die Messwerte 20d und 20e voneinander abweichen.

Mit anderen Worten kann die Empfindlichkeit der Lichterfassungskomponente 10 temperaturabhängig sein. Im Falle, beispielsweise, eines Photomultipliers, einer Photodiode, eines lichtempfindlichen Widerstands oder eines sonstigen optischen Sensors als Lichterfassungskomponente 10, kann zudem eine zeitliche Drift der Empfindlichkeit hinzutreten, die auch durch eine künstliche Alterung vor Einbau in einer Anlage oder Prüfanlage nicht kompensiert werden kann.

Dies kann problematisch sein, weil eine Anlage, in der die Lichterfassungskomponente 10 verbaut ist, beispielsweise beim Anlaufen oder wenn das Werkshallentor offensteht, beispielsweise eine Temperatur von ϑ₁ = 20°C aufweisen, während es sein kann, dass nach einem längeren Betrieb eine Temperatur von ϑ₂ = 60°C oder ϑ₂ = 70°C gemessen werden kann.

Im Falle einer Prüfung eines Wert- oder Sicherheitsdokuments kann dann eine Situation auftreten, in der eine Prüfung auf Echtheit bei unterschiedlichen Temperaturen unterschiedlich ausfallen kann. Dies gilt es zu vermeiden, um die Echtheitsprüfung mit hoher Zuverlässigkeit durchführen zu können.

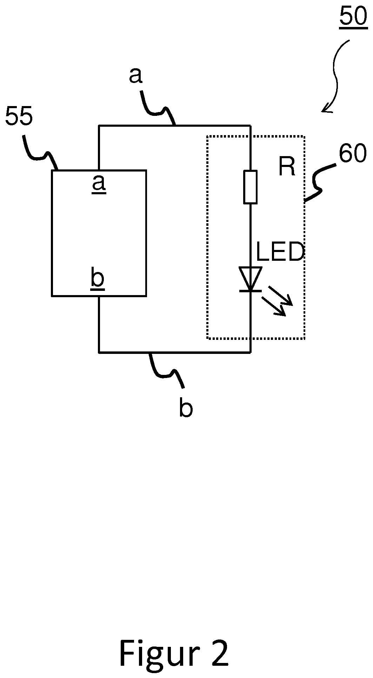

Figur 2 zeigt eine alternative Referenzlichtquelle 50, die aus einer preiswerten LED (Leuchtdiode, Light Emitting Diode) mit Vorwiderstand gebildet ist und mit 60 bezeichnet ist, welche über Leitungen a und b, welche aus Anschlüssen a und b einer elektrischen Energieversorgung 55 gebildet sein kann, versorgt sein kann.

Eine derartige alternative Referenzlichtquelle kann in einer industriellen Produktionsanlage oder industriellen Prüfanlage anstelle der relativ teuren Referenzlichtquelle verbaut sein, so dass die Lichterfassungskomponente 10 jederzeit neu kalibriert werden kann. Allerdings ist eine Emission einer LED temperaturabhängig, so dass eine zuverlässige Kalibrierung ohne Weiteres nicht möglich ist.

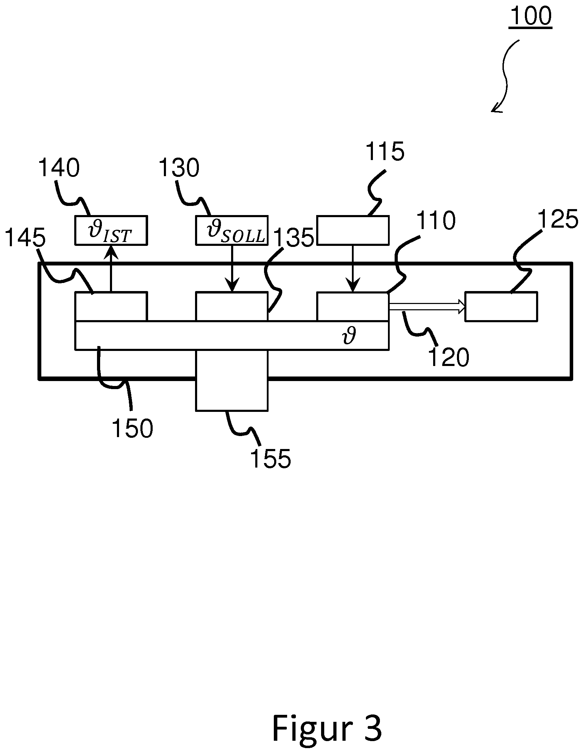

Figur 3 veranschaulicht eine Anordnung 100 zur Bestimmung eines temperaturstabilisierten Arbeitspunktes einer eine LED umfassenden Referenzlichtquellenanordnung. Eine programmierbare Spannungsquelle 115 versorgt eine mit einem Vorwiderstand und einer Leuchtdiode, LED, versehene Referenzlichtquellenanordnung 110. Ein von der Referenzlichtquellenanordnung emittiertes Licht 120 kann von einer Lichtintensitätsmesseinrichtung 125 erfasst werden.

Die Anordnung 100 kann eine weitere programmierbare Spannungsquelle 130 zum Ansteuern einer oder mehrerer Temperaturkomponenten 135 aufweisen. Bei der Temperaturkomponente 135 kann es sich beispielsweise um ein Peltierelement handeln, mit dem eine Erwärmung und/oder eine Kühlung eines Wärmebads 150 möglich ist. Zusätzlich kann die Temperaturkomponente, gemeinsam oder getrennt, einen Widerstand aufweisen. Die die Temperaturkomponente 135 bildenden Elemente können von der programmierbaren Spannungsquelle 130 derart angesteuert werden, dass das Wärmebad 150 eine vorgegebene Solltemperatur ϑ*_{SOLL}* annehmen kann.

Ferner kann die Anordnung 100 ein Thermometer 145 mit Datenlogger 140 aufweisen, um eine bestehende Temperatur *ϑ_{IST}* des Wärmebads (*ϑ*) 150 zu erfassen. Das Thermometer 145 kann als Thermoelement, temperaturabhängiger Widerstand oder sonstiges temperaturabhängiges elektronisches oder elektrisches Bauelement ausgeführt sein.

Der Begriff "Wärmebad" bedeutet hier insbesondere, dass die relevanten Komponenten, nämlich Thermometer 145, Peltierelement 135, optionaler Widerstand 135 und vor allem die Referenzlichtquellenanordnung 110 thermisch derart miteinander gekoppelt sind, dass die Komponenten dieselbe oder zumindest im Wesentlichen dieselbe Temperatur aufweisen.

Die Anordnung 100 kann überdies lichtdicht ausgeführt sein.

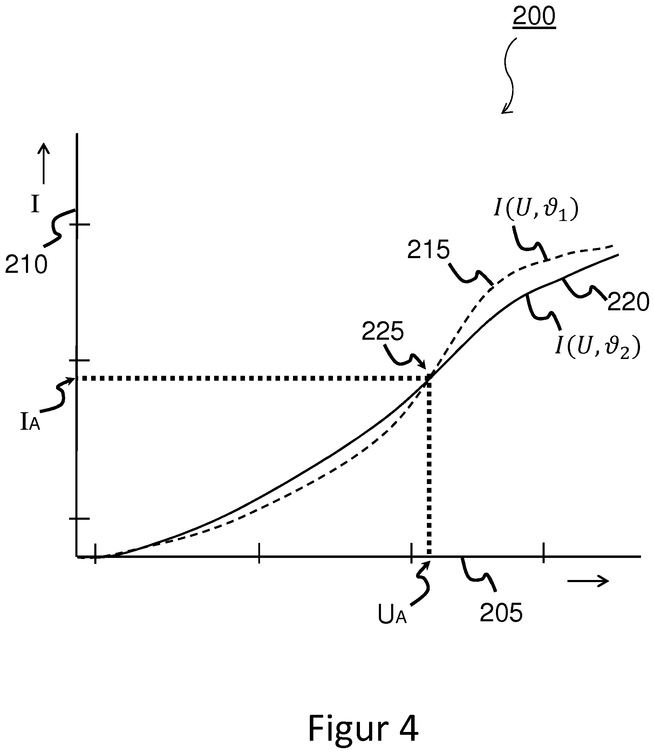

Figur 4 veranschaulicht ein Kennlinienfeld 200 zur Bestimmung eines temperaturstabilisierten Arbeitspunktes einer eine LED umfassenden Referenzlichtquellenanordnung.

Die Achse 205 repräsentiert eine Spannung *U,* die der Referenzlichtquellenanordnung 110 per programmierbarer Spannungsquelle 115 aufgeprägt sein kann. Die Achse 210 repräsentiert eine Lichtintensität *l*, die von der Lichtintensitätsmesseinrichtung 125 erfasst wird.

Zur Bestimmung eines temperaturstabilisierten Arbeitspunktes der eine LED umfassenden Referenzlichtquellenanordnung 110 wird wie folgt vorgegangen:
Zunächst wird das Wärmebad 150 auf eine erste Solltemperatur *ϑ*₁ gebracht, so dass dann insbesondere die Referenzlichtquellenanordnung 110 die Temperatur *ϑ*₁ aufweist. Dann wird die der Referenzlichtquellenanordnung 110 aufgeprägte Spannung *U* variiert. Zeitgleich erfasst die Lichtintensitätsmesseinrichtung 125 die von der Referenzlichtquellenanordnung 110, von der aufgeprägten Spannung *U* abhängige, emittierte Lichtintensität *l*. Auf diese Weise wird eine erste Emissionskennlinie 215 (unterbrochen gezeigt) der Referenzlichtquellenanordnung 110 erfasst. Dem Fachmann ist klar, dass die Spannungsvariation mit einer dementsprechenden Stromvariation einhergeht. Insofern werden im Folgenden Spannungsvariation und Stromvariation als gleichbedeutend angesehen, wenngleich klar ist, dass im vorliegenden Fall der Referenzlichtquellenanordnung 110 die Spannung aufgeprägt wird und sich der Strom dementsprechend einstellt. Ebenso ist klar, dass, wenn ein Arbeitspunkt gefunden ist, bei vorgegebenem Vorwiderstand eine bestimmte Spannung aufzuprägen ist, alternativ ein dementsprechender Strom einzuprägen ist.

Hernach wird das Wärmebad 150 auf eine zweite Temperatur *ϑ*₂ gebracht und, unter Stromvariation, eine zweite Emissionskennlinie 220 (durchgezogen dargestellt) der Referenzlichtquellenanordnung 110 erfasst.

Die Einstellung der jeweiligen Temperatur ϑ₁ bzw. Temperatur ϑ₂ kann durch eine Mikroprozessoransteuerung der Anordnung 100 vorgenommen werden. Die Einstellung der aufgeprägten Spannung kann ebenfalls durch die Mikroprozessoransteuerung vorgenommen werden. Die Erfassung des je emittierten Lichts 120 durch die Lichtintensitätsmesseinrichtung 125 kann ebenfalls durch die Mikroprozessorsteuerung vorgenommen werden.

Sofern die LED geeignet gewählt wurde, mit geeigneter Kennlinienform, bildet sich ein Schnittpunkt 225 der beiden erfassten Emissionskennlinien 215 und 220.

An diesem Schnittpunkt 225 emittiert die Referenzlichtquellenanordnung 110 bei aufgeprägter Spannung *U_{A}* unabhängig davon, ob die Temperatur *ϑ*₁ oder die Temperatur *ϑ*₂ vorliegt, dieselbe Lichtintensität *l_{A}*.

Somit ist in diesem Arbeitspunkt die von der Referenzlichtquellenanordnung 110 emittierte Lichtintensität im Wesentlichen unabhängig von der Temperatur. Bei präziser Messung bei Temperaturen *ϑ* mit *ϑ*₁ < *ϑ* < *ϑ*₂ können möglicherweise geringe Abweichungen auftreten, die allerdings tolerierbar sind.

Mit anderen Worten ist somit ein temperaturstabilisierter Arbeitspunkt der Referenzlichtquellenanordnung 110 gefunden.

Somit ist es möglich, mit einer relativ preiswerten Referenzlichtquellenanordnung 110, die beispielsweise nur aus einem Vorwiderstand und einer LED sowie einer aufprägbaren Spannung gebildet ist, eine temperaturunabhängige Lichtquelle zu bilden.

Dies kann in einer automatisierten Produktions- und oder Prüfanlage von Vorteil sein, wenn bestimmte Effekte nachzuweisen sind, beispielsweise eine Fluoreszenzintensität, die eine vorbestimmte Intensität aufweisen muss, oder sich in einem vorbestimmten Intensitätsintervall befinden muss.

## Patentansprüche

1. Verfahren zur Bestimmung eines temperaturstabilisierten Arbeitspunktes (225) einer aus einer LED (60) gebildeten Referenzlichtquellenanordnung (110), umfassend:
a) bei einer ersten Temperatur (*ϑ*₁): Erfassen, unter Stromvariation, einer ersten Emissionskennlinie (215) der Referenzlichtquellenanordnung;
b) bei einer zweiten Temperatur (ϑ₂): Erfassen, unter Stromvariation, einer zweiten Emissionskennlinie (220) der Referenzlichtquellenanordnung;
c) nach Aufnahme der ersten Emissionskennlinie und der zweiten Emissionskennlinie:
i. Auffinden eines von null verschiedenen Stromes, bei dem der diesem Strom zugeordnete Intensitätswert (*I*_{A}) auf der ersten Emissionskennlinie denselben Intensitätswert wie der diesem Strom zugeordnete Intensitätswert auf der zweiten Emissionskennlinie hat; und
ii. Wahl des so bestimmten Stromes als Strom des Arbeitspunktes.

2. Verfahren nach Anspruch 1, wobei die Stromvariation durch Variation einer aufgeprägten Spannung (*U*) bewirkt wird.

3. Verfahren nach einem der voranstehenden Ansprüche, wobei die Stromvariationen und die Temperatureinstellungen automatisiert vorgenommen werden.

4. Verfahren nach einem der voranstehenden Ansprüche, wobei die erfassten Emissionskennlinien automatisiert erfasst werden.

5. Verfahren nach einem der voranstehenden Ansprüche, wobei der Arbeitspunkt automatisiert bestimmt wird.

6. Vorrichtung, eingerichtet zur Ausführung eines Verfahrens nach einem der voranstehenden Ansprüche.

## Claims

1. A method for determining a temperature-stabilized operating point (225) of a reference light source arrangement (110) formed from an LED (60), comprising:
a) detecting, at a first temperature (ϑ₁): under current variation, of a first emission characteristic (215) of the reference light source arrangement;
a) detecting, at a second temperature (ϑ₂): under current variation, of a second emission characteristic (220) of the reference light source arrangement;
c) after recording the first emission characteristic and the second emission characteristic:
i. finding a current different from zero, at which the intensity value (*I*_{A}) assigned to this current has the same intensity value on the first emission characteristic as the intensity value assigned to this current on the second emission characteristic; and
ii. choosing the thus-determined current as current of the operating point.

2. The method according to claim 1, wherein the current variation is effected by varying an applied voltage (*U*).

3. The method according to one of the preceding claims, wherein the current variations and the temperature settings are undertaken automatically.

4. The method according to one of the preceding claims, wherein the detected emission characteristics are detected automatically.

5. The method according to one of the preceding claims, wherein the operating point is determined automatically.

6. A device configred for executing a method according to one of the preceding claims.

## Revendications

1. Procédé, destiné à déterminer un point de travail (225) stabilisé en température d'une configuration de source lumineuse de référence (110) formée de DEL (60), comprenant :
a) à une première température (ϑ₁) : la détection, sous une variation de courant d'une première courbe caractéristique d'émission (215) de la configuration de source lumineuse de référence ;
b) à une deuxième température (ϑ₂), la détection sous une variation de courant d'une deuxième courbe caractéristique d'émission (220) de la configuration de source lumineuse de référence ;
c) après l'enregistrement de la première courbe caractéristique d'émission et de la deuxième courbe caractéristique d'émission :
i. trouver un courant différent de zéro, avec lequel la valeur d'intensité (*I*_{A}) associé audit courant possède sur la première courbe caractéristique d'émission la même valeur d'intensité que la valeur d'intensité associée audit courant sur la deuxième courbe caractéristique d'émission ; et
ii. choisir le courant déterminé de cette manière comme étant le courant du point de travail.

2. Procédé selon la revendication 1, la variation de courant étant provoquée par une variation d'une tension appliquée (*U*).

3. Procédé selon l'une quelconque des revendications précédentes, les variations de courant et les réglages de température étant réalisés de manière automatisée.

4. Procédé selon l'une quelconque des revendications précédentes, les courbes caractéristiques d'émission détectées étant détectées de manière automatisée.

5. Procédé selon l'une quelconque des revendications précédentes, le point de travail étant déterminé de manière automatisée.

6. Dispositif, aménagé pour réaliser un procédé selon l'une quelconque des revendications précédentes.
